# FASCICULE DE BREVET EUROPEEN

(11) **EP 0 617 839 B1**
(45) Date de publication et mention de la délivrance du brevet: **11.03.1998**
(21) Numéro de dépôt: 93902300.8
(22) Date de dépôt: 04.12.1992
(51) Int. Cl.: H01L 21/78

(54) **Procédé de réalisation de composants semi-conducteurs, notamment sur GaAs ou InP, avec récupération du substrat par voie chimique**
Verfahren zur Herstellung von Halbleiterkomponenten, insbesondere auf GaAs oder InP, bei dem das Substrat auf chemischem Wege wiedergewonnen wird
Method of making semiconductor components, in particular on GaAs or InP, with recovery of the substrate by chemical means

(30) Priorité: 06.12.1991 FR 9115139
(43) Date de publication de la demande: 05.10.1994
(73) Titulaire: PICOGIGA S.A., 91940 Les Ulis (FR)
(72) Inventeur: NUYEN, Linh, T., F-75016 Paris (FR)
(74) Mandataire: Dupuis-Latour, Dominique
(86) Numéro de dépôt international: FR9201152
(87) Numéro de publication internationale: WO9311559

(56) Documents cités:
- EP-A- 0 029 334
- FR-A- 2 593 326
- Journal of Crystal Growth 45(1978),North-Holland Publishing Comp.,M. KONAGAI et al.: Efficiency GaAs Thin Film Solar Cells by Peeled Film Technology cited in the application
- JAPANESE JOURNAL OF APPLIED PHYSICS. vol. 23, no. 10/2, October 1984, TOKYO JP pages 815 - 817 T. HAMAGUCHI ET AL. 'Device Layer Transfer Technique Using Chemi-Mechanical Polishing'

## Description

L'invention concerne un procédé de réalisation de composants électroniques à base de matériaux semiconducteurs III-V.

Il s'agit plus particulièrement de composants réalisés sur substrats GaAs ou InP, essentiellement des composants comportant comme couche active AlₓGa₁₋ₓAs (sur GaAs) ou AlₓIn₁₋ₓAs (sur InP).

Il a déjà été proposé de réaliser de tels composants électroniques et de les séparer ensuite de leur substrat GaAs ou InP par dissolution d'une couche AlₓGa₁₋ₓAs intercalaire à forte teneur en aluminium (fraction molaire x_{Al} ≥ 0,50) épitaxiée au préalable entre le substrat et les couches actives de matériau semiconducteur constituant le composant électronique proprement dit. On pourra se référer à cet égard à M. Konagai et al., *High Efficiency GaAs Thin Film Solar Cells by Peeled Film Technology,* Journal of Crystal Growth, n°45 (1978), p. 277, E. Yablonovitch et al., *Extreme Selectivity in the Lift-Off of Epitaxial GaAs Films,* Appl. Phys. Lett., Vol. 51, n° 26, 28 décembre 1987, p. 222, ou encore H. Schumacher et al., *High-Speed InP/GalnIAs Photodiode on Sapphire Substrate,* Electronics Letters, Vol. 25, n° 24, 23 novembre 1989, p. 1653.

Le EP-A-0 029 334 décrit une technique de même nature, mais avec dissolution complète du substrat.

Cette technique consistant à séparer les composants du substrat sur lequel ils ont été réalisés présente un nombre important d'avantages.

En premier lieu, elle permet de réduire l'épaisseur du composant par suppression complète du substrat, avec tous les avantages corrélatifs qui en découlent : le substrat étant éliminé, il n'est plus nécessaire de réaliser des vias pour le traverser et assurer la prise de contact à la couche inférieure du composant ; le coût de fabrication de ce dernier en est donc diminué d'autant : le poids du composant est considérablement réduit, ce qui est avantageux dans le domaine spatial ; pour certaines applications optoéiectroniques, le substrat peut constituer une gêne car il n'est pas transparent aux longueurs d'onde concernées ; et enfin la dissipation thermique est considérablement améliorée du fait de la suppression de la résistance thermique constituée, dans les composants actuels, par la présence du substrat (GaAs et InP étant mauvais conducteurs de la chaleur).

En second lieu, et surtout, le procédé de l'invention permet la récupération du matériau du substrat, sans destruction de celui-ci, économisant ainsi, outre le coût de l'étape de rodage, le coût du substrat, qui pourra être réutilisé tel quel.

Cette technique de séparation du substrat par dissolution chimique est basée sur le fait que le composé AlₓGa₁₋ₓAs à forte teneur en aluminium(x_{Al} ≥ 0,50) constituant la couche intercalaire se dissout très rapidement dans l'acide chlorhydrique ou fluorhydrique, à la différence de GaAs ou Al_{y}Ga_{1-y}As à faible teneur en aluminiun (y_{Al} < 0.30).

De par son principe même, cette technique ne peut donc être directement transposée au cas où le composant proprement dit comporte, dans sa couche active, des couches riches en aluminium telles que Al_{y}Ga_{1-y}As (avec y_{Al} ≥ 0,50 environ) sur substrat GaAs, ou Al_{y}In_{1-y}As (avec y_{Al} ≥ 0.50 environ) sur substrat InP, car ces couches riches en aluminium subissent elles-mêmes une attaque par les acides.

En effet, comme indiqué dans l'article précité de Yablonovitch et al., on constate une sélectivité très forte de la vitesse d'attaque en fonction de la composition de la couche, cette vitesse croissant très brutalement dès que la fraction molaire d'aluminium dépasse un seuil de 40 à 50%.

Il a été récemment proposé par A.J. Tsao et al., *Epitaxial Liftoff of ALAs* / *GaAs Double Barrier Resonant Tunnelling Diodes,* Electronics Letters, Vol. 27, n° 6. 14 mars 1991, p. 484, de recouvrir le flanc du composant par une graisse inerte, connue dans la technique sous le terme «graisse Apiezon», protégeant ainsi celui-ci de l'attaque acide des parties des couches riches en aluminium.

Toutefois, cette technique est difficilement adaptable à une production de masse des composants électroniques, du fait notamment de la difficulté d'étaler convenablement la graisse Apiezon sur le flanc des composants ; en fait. cette technique ne peut guère être envisagée que dans le cas, visé par l'article en question, de composants très spécifiques traités isolément.

Le but de la présente invention est de proposer un procédé de réalisation de composants avec récupération du substrat, facilement contrôlable et aisément industrialisable, permettant en outre de protéger de manière précise les flancs des composants à l'égard de l'attaque chimique.

A cet effet, le procédé de l'invention est énoncé en revendication 1. Les sous-revendications visent des modes de mise en oeuvre avantageux.

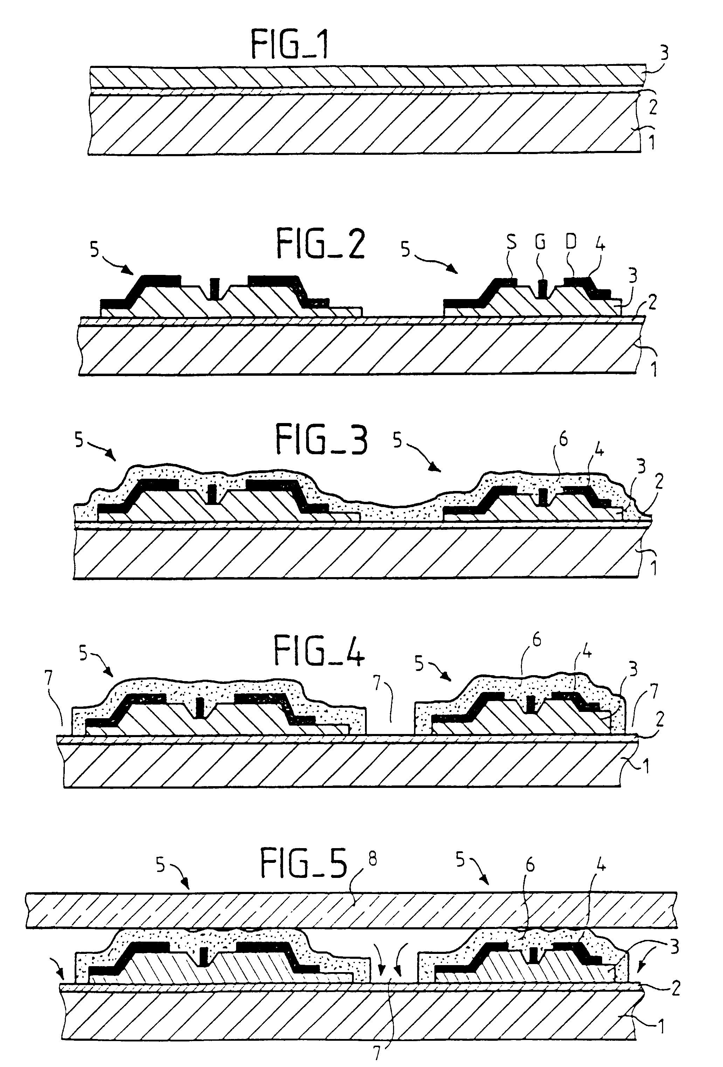

On va maintenant décrire un exemple de mise en oeuvre de l'invention, en référence aux dessins annexés sur lesquels les figures 1 à 9 illustrent, de façon schématique, les différentes étapes de réalisation d'un composant selon le procédé de l'invention.

Le composant décrit sur ces figures est bien entendu donné uniquement à titre d'exemple, et pourrait aussi bien être d'un autre type ou d'une autre configuration.

Sur la figure 1, on a représenté en couches la tranche de départ, comprenant un substrat 1, épais (typiquement d'une épaisseur de l'ordre de 500 micromètres) en GaAs ou InP, sur lequel on épitaxie en 2 une couche intercalaire de AlₓGa₁₋ₓAs à forte teneur en aluminium sur une très faible épaisseur (par exemple de l'ordre de quelques dizaines de nanomètres). Sur cette couche intercalaire 2, on épitaxie ensuite une couche 3 dont le dopage, l'épaisseur et la constitution seront choisis en fonction du composant à réaliser.

Cette couche active 3 est en fait généralement constituée d'un empilement de couches successives présentant chacune une composition, un dopage et une épaisseur différents, le terme « couche active» désignant ici collectivement cet empilement.

L'invention concerne le cas où cette couche active 3, tout comme la couche intercalaire 2, comporte un matériau à forte teneur en aluminium, par exemple Al_{y}Ga_{1-y}As avec y_{Al} ≥ 0,50 ou Al_{y}In_{1-y}As avec y_{Al} ≥ 0,50.

À l'étape de la figure 2, on a exécuté diverses étapes de procédé connues de gravure chimique, ionique ou ionique réactive de la couche active 3, de dépôt d'une métallisation 4, etc. de manière à constituer les divers composants individuels 5 avec leurs électrodes de source S, de grille G et de drain D. On notera que l'on peut réaliser aussi bien des composants isolés (transistors individuels) que des groupes de composants, qui peuvent correspondre à une fonction logique ou analogique donnée, les divers composants élémentaires de ces groupes de composants étant alors réalisés sur une même région de la couche active 3 et reliés entre eux par des métallisation appropriées.

À l'étape de la figure 3, caractéristique de l'invention, on a revêtu l'ensemble des composants d'une couche de protection 6 d'un matériau inerte, qui peut être en particulier une résine photosensible ou une couche de passivation du composant (couche d'oxyde ou de nitrure), déposée par une voie classique.

À l'étape de la figure 4, on a gravé la couche de protection 6 de manière à mettre à nu, dans des régions repérées 7, la couche intercalaire 2 riche en aluminium, tout en protégeant les flancs des composants ou groupes de composants qui sont alors en forme d'îlots isolés les uns des autres sur le substrat. Ces ouvertures 7 sont réalisées par les techniques classiques de photolithographie ou de lithographie électronique, dans le cas d'une couche en résine photosensible) ou de gravure, dans le cas d'une couche de passivation.

À l'étape de la figure 5, on vient recouvrir l'ensemble des composants par une plaque commune 8, par exemple collée sur la couche protectrice 6 après dépôt de cette dernière. On choisira, pour les raisons que l'on expliquera plus bas, une colle non soluble dans l'acide.

Une fois la plaque 8 collée, on trempe l'ensemble plaque + tranche gravée dans un bain d'acide dilué, par exemple de l'acide chlorhydrique à 50%, ce choix d'acide n'étant en aucune façon limitatif.

Cette opération a pour effet d'attaquer la couche 2 riche en aluminium, l'acide pénétrant par les interstices formés entre les composants et venant attaquer la couche de AlₓGa₁₋ₓAs aux endroits 7 mis à nu, puis par le chant de cette couche, comme illustré par les flèches de la figure 5. Le reste de la structure, notamment le substrat GaAs ou InP, les régions protégées par la couche inerte 6, la plaque support 8 et la colle qui la retient au composant, est en revanche laissé intact.

Bien entendu, le matériau constituant la face inférieure de la couche active 3, qui est en contact avec la couche intercalaire 2, présente une faible teneur en aluminium, autrement le composant serait attaqué par le dessous lors de la dissolution de la couche intercalaire 2. Ce matériau est généralement une couche de GaAs, InP ou GaₓIn₁₋ₓAs, les couches de AlₓGa₁₋ₓAs riche en aluminium étant situées plus haut dans l'empilement de couches de la couche active 3.

Ainsi, si l'on réalise par exemple une couche épitaxiale de AlₓGa₁₋ₓAs de plusieurs dizaines de nanomètres, l'immersion pendant une nuit dans HCl dilué à 50% montre une attaque totale de ce matériau sur une surface de tranche de 2 pouces de diamètre (5 cm environ), le substrat GaAs se détachant de lui-même des composants. La tranche de substrat ainsi détachée, qui n'a pas été attaquée par l'acide, est parfaitement réutilisable pour la réalisation d'autres composants sur cette même tranche.

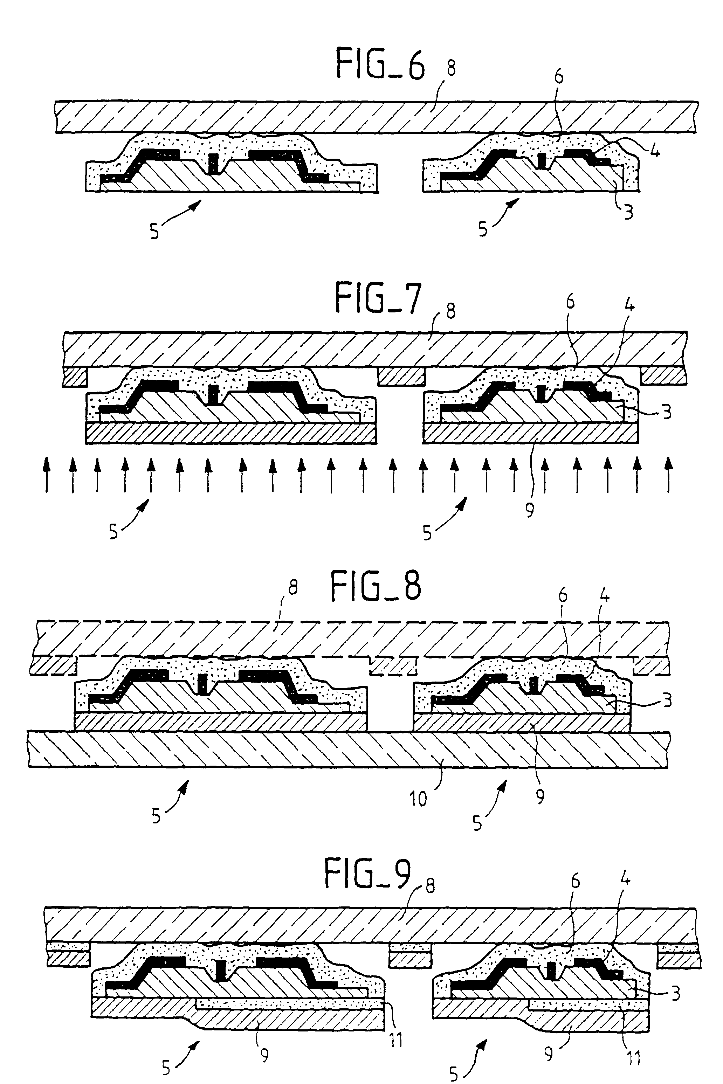

On aboutit ainsi à la situation de la figure 6.

A la figure 7, le processus se poursuit par dépôt d'une métallisation 9 de la face libre, c'est-à-dire de la face postérieure de la couche dopée 3. La métallisation 9 peut être déposée par toute méthode classique (évaporation, etc.), ce qui permet une prise de contact direct sur la face arrière de la couche dopée sans interposition du substrat, et donc sans avoir besoin de former des vias ; en outre, du fait de ce contact direct, cette métallisation joue efficacement un rôle de drain thermique.

Les opérations peuvent se poursuivre de diverses manières.

On peut tout d'abord dissoudre la colle afin de séparer de la plaque support 8 les composants individuels 5 ou groupes de composants et récupérer les différentes puces.

Il est également possible, avant de dissoudre la colle, de fixer l'ensemble sur une « peau de tambour » selon une méthode connue, permettant ainsi de retenir et de séparer plus aisément les diverses puces après dissolution de la colle.

Par ailleurs, pour certaines applications telles que les cellules solaires ou les diodes électroluminescentes, on peut préférer laisser la plaque collée afin d'avoir un réseau de composants interconnectés électriquement (soit sur cette plaque elle-même, soit d'une autre manière). On peut ainsi réaliser directement des panneaux électroluminescents de grande dimension, la plaque 8 étant alors une plaque transparente en une matière appropriée, minérale ou organique.

Il est également possible, une fois le réseau réalisé, de coller les composants, par leur face inférieure, sur une autre plaque support 10, comme illustré figure 8, afin d'obtenir une structure « sandwich » électroluminescente ou photosensible, formée d'un réseau de diodes retenues entre deux plaques 8 et 10 de protection et de maintien.

On peut également, après collage sur la plaque postérieure 10, décoller la plaque frontale 8, celle-ci ne jouant alors le rôle que de support provisoire avant report des composants sur la plaque support définitive 10.

Par ailleurs, la plaque support peut elle-même être un composant actif.

En outre, comme illustré figure 9, on peut prévoir de déposer avant métallisation une couche isolante 11 en regard de l'électrode de drain du transistor afin de réduire les capacités parasites qui pourraient résulter de la trop grande proximité de cette électrode et de la métallisation de la face arrière (puisque le substrat est maintenant absent).

## Revendications

1. Un procédé de réalisation de composants semiconducteurs, caractérisé par les étapes consistant à :
(a) produire un substrat (1) en matériau semiconducteur III-V binaire ou ternaire et non soluble par une action chimique donnée,
(b) épitaxier sur ce substrat une couche intercalaire (2) en un matériau semiconducteur III-V ternaire présentant une fraction molaire d'aluminium d'au moins 40%, de maille atomique compatible avec celle du substrat et soluble par ladite action chimique,
(c) épitaxier sur cette couche intercalaire une couche active (3) comportant un matériau semiconducteur III-V binaire ou ternaire présentant une fraction molaire d'aluminium d'au moins 30%, cette couche active étant de maille atomique compatible avec celle de la couche intercalaire,
(d) réaliser, par gravure et métallisation de cette couche active, un ensemble de composants semiconducteurs (5), des régions de la couche intercalaire étant mises à nu par ladite gravure entre ces composants ou des groupes de ces composants,
(e) applique sur cet ensemble de composants et sur lesdites régions mises à nu une couche protectrice (6) d'un matériau de passivation ou d'une résine photosensible, résistant à ladite action chimique,
(f) graver cette couche protectrice jusqu'à mettre à nu la couche intercalaire à l'endroit desdites régions entre les composants ou entre des groupes de ces composants,
(g) fixer sur l'ensemble ainsi réalisé une plaque support commune (8) recouvrant et solidarisant mécaniquement les composants, et
(h) séparer, sans le dissoudre, le substrat d'avec les composants ou groupes de composants par dissolution du matériau de la couche intercalaire par ladite action chimique aux endroits (7) mis à nu à l'étape (f), en laissant intacts les autres matériaux, une face arrière de la couche active (3) desdits composants ou groupes de composants étant ainsi découverte.

2. Le procédé de la revendication 1, comprenant en outre une étape consistant à :
(i) déposer une métallisation (9) sur ladite face arrière de la couche active des composants ou groupes de composants découverte par la séparation du substrat à l'étape (h).

3. Le procédé de la revendication 1 ou 2, comprenant en outre une étape consistant à :
(k) séparer les différents composants individuels ou groupes de composants d'avec ladite plaque support commune.

4. Le procédé de l'une des revendications 1 à 3, comprenant en outre une étape consistant à:
(j) fixer un organe support commun (10) sur ladite face arrière des différents composants individuels ou groupes de composants.

5. Le procédé de la revendication 4, dans lequel ledit organe support commun porte des lignes d'interconnexion des composants.

6. Le procédé de l'une des revendications 4 ou 5, dans lequel ledit organe support commun est optiquement transparent et les composants sont des composants optoélectroniques.

7. Le procédé de l'une des revendications 1 à 6, dans lequel ladite plaque support commune porte des lignes d'interconnexion des composants.

8. Le procédé de l'une des revendications 1 à 7, dans lequel ladite plaque support commune est optiquement transparente et les composants sont des composants optoélectroniques.

## Patentansprüche

1. Verfahren zur Herstellung von Halbleiterkomponenten, gekennzeichnet durch die Schritte:
(a) Erzeugen eines Substrates (1) aus einem binären oder tertiären und nicht durch chemische Wirkung lösbaren gegebenen Halbleitermaterial (III-V),
(b) Epitaxieren einer Zwischenschicht (2) auf diesem Substrat aus tertiärem Halbleitermaterial (III-V), das einen Molanteil von Aluminium von zumindest 40 % aufweist, mit einem Atomgitterabstand, der kompatibel mit dem des Substrates und lösbar durch die chemische Wirkung ist,
(c) Epitaxieren auf dieser Zwischenschicht einer aktiven Schicht (3), die ein binäres oder tertiäres Halbleitermaterial (III-V) aufweist, das einen Molanteil von Aluminium von zumindest 30 % aufweist, wobei der Atomgitterabstand dieser aktiven Schicht mit dem der Zwischenschicht kompatibel ist,
(d) Realisieren durch Gravur und Metallisierung dieser aktiven Schicht eine Gesamtheit von Halbleiterkomponenten (5), wobei Bereiche der Zwischenschicht durch die Gravur zwischen diesen Komponenten oder Gruppen dieser Komponenten freigelegt werden,
(e) Aufbringen einer Schutzschicht (6) aus einem Passivierungsmaterial oder aus einem fotoempfindlichen Harz, das der chemischen Wirkung widersteht, auf dieser Gesamtheit von Komponenten oder auf den freigelegten Bereichen,
(f) Gravieren dieser Schutzschicht bis zum Freilegen der Zwischenschicht am Ort dieser Bereiche zwischen den Komponenten oder zwischen Gruppen dieser Komponenten,
(g) Befestigen einer gemeinsamen Trägerplatte (8), die mechanisch die Komponenten überdeckt und verbindet, auf der so realisierten Gesamtheit, und
h) Trennen des Substrats, ohne es aufzulösen, von den Komponenten oder Gruppen von Komponenten durch Auflösung des Materials der Zwischenschicht durch die chemische Wirkung an den Orten (7), die in Schritt (f) freigelegt worden sind, wobei die anderen Materialien intakt gelassen werden und wobei eine hintere Seite der aktiven Schicht (3) der Komponenten oder Gruppen von Komponenten so aufgedeckt wird.

2. Verfahren gemäß Anspruch 1, das außerdem einen Schritt aufweist, der darin besteht:
(i) eine Metallisierung (9) auf der hinteren Seite der aktiven Schicht der Komponenten oder Gruppen von Komponenten aufzubringen, die bei dem Schritt (h) durch die Trennung von dem Substrat aufgedeckt worden sind.

3. Verfahren gemäß Anspruch 1 oder 2, das außerdem einen Schritt aufweist, der darin besteht:
(k) die unterschiedlichen individuellen Komponenten oder Gruppen von Komponenten von der gemeinsamen Trägerplatte zu trennen.

4. Verfahren gemäß einem der Ansprüche 1 bis 3, das außerdem einen Schritt aufweist, der darin besteht:
(j) ein gemeinsames Trägerelement (10) auf der hinteren Seite der unterschiedlichen individuellen Komponenten oder Gruppen von Komponenten zu befestigen.

5. Verfahren gemäß Anspruch 4, bei dem das gemeinsame Trägerelement Verbindungslinien der Komponenten trägt.

6. Verfahren gemäß einem der Ansprüche 4 oder 5, bei dem das gemeinsame Trägerelement optisch transparent ist und die Komponenten optoelektronische Komponenten sind.

7. Verfahren gemäß einem der Ansprüche 1 bis 6, bei dem die gemeinsame Trägerplatte Verbindungslinien der Komponenten trägt.

8. Verfahren gemäß einem der Ansprüche 1 bis 7, bei dem die gemeinsame Trägerplatte optisch transparent ist und die Komponenten optoelektronische Komponenten sind.

## Claims

1. A method of making semiconductor components, characterized by the following steps :
(a) producing a substrate (1) of binary or ternary III-V semiconductor material which is not dissolvable by a given chemical action,
(b) epitaxially growing on said substrate an intermediate layer (2) of a ternary III-V semiconductor material which has a molar fraction of aluminium of at least 40 %, an atomic lattice parameter compatible with that of the substrate and which is dissolvable by said chemical action,
(c) epitaxially growing on said intermediate an active layer (3) of a binary or ternary III-V semiconductor material which has a molar fraction of aluminium of at least 30 %, said active layer having an atomic lattice parameter compatible with that of the intermediate layer,
(d) making, by etching and metallizing said active layer, a set of semiconductor components (5), certain areas of the intermediate layer being bared by said etching between said components or groups of said components,
(e) applying on said set of semiconductor components and on said exposed areas a protective layer (6) of a passivation material, or of a photosensitive resin, which is resistant to said chemical action,
(f) etching said protective layer so as to bare the intermediate layer at said areas between said components or between groups of said components,
(g) fixing on the resulting assembly a common support plate (8) covering and mechanically holding the components together, and
(h) separating the substrate, without dissolving it, from the components or groups of components by dissolving the material of the intermediate layer by said chemical action at the locations (7) bared at step (f), letting the other materials unaltered, wherein a rear face of the active layer (3) of said components or groups of components is thus uncovered.

2. The method of claim 1, further including the following step :
(i) depositing a metallization (9) on said rear face of the active layer of the components or groups of components uncovered by separating the substrate at step (h).

3. The method of claim 1 or 2, further including the following step :
(k) separating the different individual components or groups of components from said common support plate.

4. The method of claim 1 to 3, further including the following step :
(j) fixing a common support member (10) on said rear face of said components or groups of components.

5. The method of claim 4, wherein said common support member carry component interconnection lines.

6. The method of claim 4 or 5, wherein said common support member is optically transparent and said components are optoelectronic components.

7. The method of any one of claims 1 to 6, wherein said common support plate carry component interconnection lines.

8. The method of any one of claims 1 to 7, wherein said common support plate is optically transparent and said components are optoelectronic components.
